# EUROPEAN PATENT APPLICATION

(11) **EP 1 003 287 A1**
(43) Date of publication of application: **24.05.2000**
(21) Application number: 99924014.6
(22) Date of filing: 11.06.1999
(51) Int. Cl.: H03H 9/64

(54) **SURFACE ACOUSTIC WAVE FILTER, AND SHARED DEVICE FOR ANTENNA**

(30) Priority: 12.06.1998 JP 16488898
(71) Applicant: MATSUSHITA ELECTRIC INDUSTRIAL CO., LTD., Kadoma-shi, Osaka 571-8501 (JP)
(72) Inventor: SAKURAGAWA, Toru, Osaka 570-0066 (JP); YUDA, Naoki, Osaka 573-0091 (JP); FUJII, Katsuya, Osaka 576-0021 (JP); MURAKAMI, Kozo, Osaka 534-0016 (JP)
(74) Representative: Grünecker, Kinkeldey, Stockmair & Schwanhäusser Anwaltssozietät
(86) International application number: JP9903141
(87) International publication number: WO9965141

(57) **Abstract**

The present invention relates to a surface acoustic wave filter for use in a mobile communication device such as a portable telephone. As for the surface acoustic wave filter provided with a plurality of serially connected surface acoustic wave resonators, the invention aims at realizing the filter that is simple to design. The invention comprises a grounding electrode 12, serially connected surface acoustic wave resonators 15a through 15c, coupling electrodes 16a through 16d for the resonators, and inter-digital electrodes 20a through 20d formed from the coupling electrodes 16a through 16d, all formed on a surface of a piezoelectric substrate 11. The surface acoustic wave resonators 15a through 15c and capacitances 19a through 19d can be designed independently with respect to each other, as the capacitances 19a through 19d are formed by the inter-digital electrodes 20a through 20d and the grounding electrode 12.

## Description

### FIELD OF THE INVENTION

The present invention relates to a surface acoustic wave filter for use in a mobile communication device such as a portable telephone, and an antenna duplexer using the same.

### BACKGROUND OF THE INVENTION

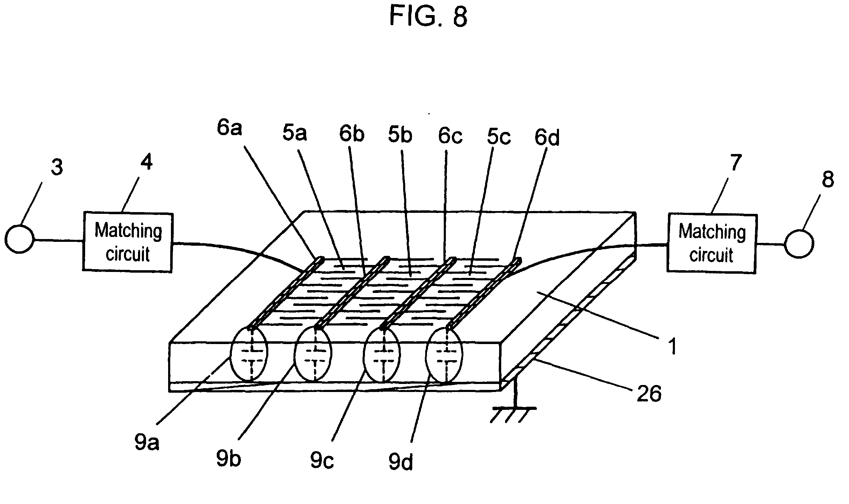

A surface acoustic wave filter used in a high frequency section of a mobile communication device such as a portable telephone has a structure, in general, as shown in Fig. 8.

That is, with reference to the figure, a reference numeral 1 represents a piezoelectric substrate, and a reference numeral 26 represents a rear surface electrode formed on a rear surface of the piezoelectric substrate 1 for grounding. A reference numeral 4 represents an input matching circuit, one of which terminals is connected to an input terminal 3. Reference characters 5a through 5c represent surface acoustic wave resonators formed on a front surface of the piezoelectric substrate 1, and a reference character 6a represents a coupling electrode for electrically connecting the surface acoustic wave resonator 5a with the other terminal of the input matching circuit 4 not connected to the input terminal 3. Reference characters 6b and 6c represent coupling electrodes for electrically connecting in series between the surface acoustic wave resonators 5a and 5b, and between 5b and 5c respectively. A reference character 6d represents a coupling electrode for electrically connecting the surface acoustic wave resonator 5c with one of terminals of an output matching circuit 7. As a reference numeral 7 is the output matching circuit, of which one of the terminals is connected to the coupling electrode 6d, the other terminal is electrically connected to an output terminal 8.

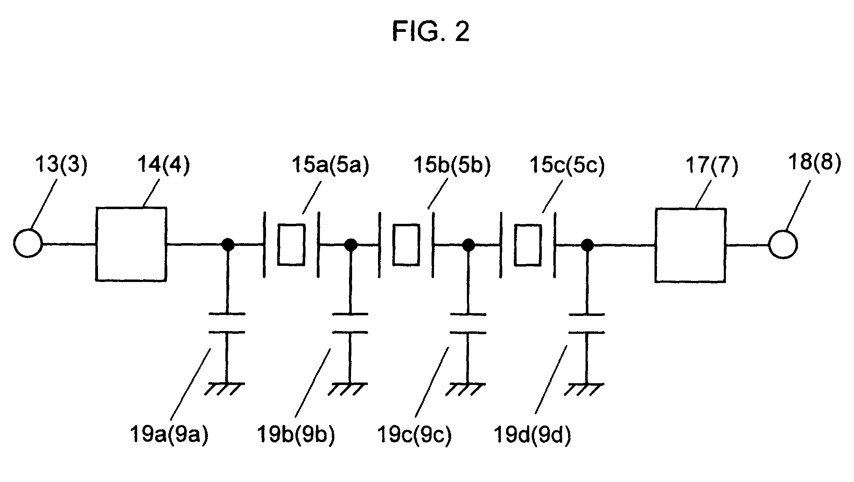

Fig. 2 shows an equivalent circuit of the surface acoustic wave filter of Fig. 8. Capacitances 9a through 9d are formed between the surface acoustic wave resonators 5a through 5c together with the coupling electrodes 6a through 6d and the rear surface electrode 26 via the piezoelectric substrate 1.

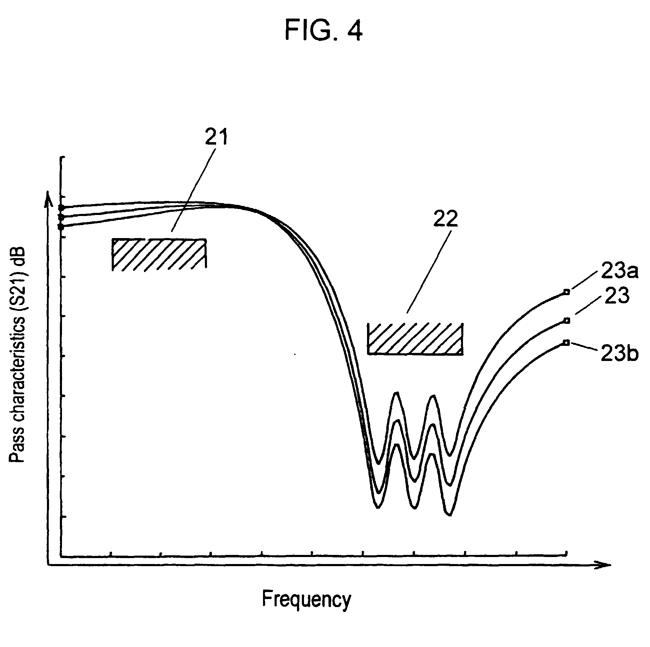

A frequency characteristic curve 23 in Fig. 4 depicts a frequency characteristic of the surface acoustic wave filter of Fig. 8, representing a band-elimination filter having a pass band 21 and a stop band 22.

In this instance, the stop band 22 is produced by the surface acoustic wave resonators 5a through 5c due to their own parallel resonance, and that frequencies of the parallel resonance are shifted in order to broaden the stop band 22. Furthermore, the input matching circuit 4 and the output matching circuit 7 are adjusted to maintain an impedance matching in the pass band 21.

A surface acoustic wave filter similar to the one shown in Fig. 8 has been disclosed in U.S. Patent Number 4,734,664, whereby it is well known that a power-resisting property increases by forming the capacitances 9a through 9d between the surface acoustic wave resonators 5a through 5c together with the coupling electrodes 6a through 6d and the rear surface electrode 26 via the piezoelectric substrate 1.

A problem associated with the foregoing structure is that it restricts a degree of flexibility in designing the capacitances 9a through 9d, which compose the surface acoustic wave filter. A reason is described hereinafter in detail.

The capacitances 9a through 9d in Fig. 2 have a great effect on an electrical characteristic of the pass band 21 and the stop band 22 of the surface acoustic wave filter shown in Fig. 4. If the capacitances 9a through 9d increase, a passage loss in the pass band 21 also increases, whereas a magnitude of attenuation in the stop band 22 increases in return, as is evident by a frequency characteristic curve 23b in Fig. 4. If the capacitances 9a through 9d decrease, they yield a characteristic contrary to the above, as depicted by a frequency characteristic curve 23a in Fig. 4.

On the other hand, capacity values of the capacitances 9a through 9d are dependent upon surface areas of the surface acoustic wave resonators 5a through 5c and the coupling electrodes 6a through 6d, as well as a thickness of the piezoelectric substrate 1. Because of this reason, it is difficult to design the surface acoustic wave resonators 5a through 5c and the capacitances 9a through 9d independently in the configuration shown in Fig. 8. Although it is possible to vary capacity values of all the capacitances 9a through 9d by changing a thickness of the piezoelectric substrate 1, it also changes other capacity values that do not require any adjustment, if it is done when adjustment is needed for only certain individual capacitances. This will ultimately require an overall redesigning of the surface acoustic wave resonators. In addition, a thickness of the piezoelectric substrate 1, if excessively reduced, can become a major factor of degrading an electrical characteristic of the surface acoustic wave filter, since bulk waves propagating in a depth direction are reflected on the rear surface electrode 26.

Besides, even if the thickness of the piezoelectric substrate 1 is fixed, either the surface acoustic wave resonators 5a through 5c or the coupling electrodes 6a through 6d need to be changed in their surface areas on the piezoelectric substrate 1, in order to vary the capacitances 9a through 9d. Though the capacitances 9a through 9d can be increased or decreased by varying only surface areas of the coupling electrodes 6a through 6d, they can be decreased only to a limited value. Hence, the surface acoustic wave filter in its entirety gives a very low degree of flexibility and therefore complication in designing.

### SUMMARY OF THE INVENTION

In a surface acoustic wave filter of the above kind, the present invention is intended to improve a degree of designing flexibility.

In order to achieve this object, a surface acoustic wave filter of this invention comprises: a piezoelectric substrate; a plurality of surface acoustic wave resonators formed on a surface of the piezoelectric substrate, and electrically connected in series; a grounding electrode formed on the surface of the piezoelectric substrate; and a capacitance formed on the surface of the piezoelectric substrate, in at least one location between the grounding electrode and each terminal of the surface acoustic wave resonators.

The structure described above allows an entirely separate designing of the serially connected surface acoustic wave resonators and the capacitance formed between the grounding electrode and each terminal of the surface acoustic wave resonators, thereby realizing a simplification in designing.

### BRIEF DESCRIPTION OF THE DRAWINGS

Fig. 1 is a structural representation of a surface acoustic wave filter of a first exemplary embodiment of the present invention;
Fig. 2 is a diagram depicting an equivalent circuit of the same surface acoustic wave filter;
Fig. 3 is a circuit diagram depicting an example of an input matching circuit and an output matching circuit for the same surface acoustic wave filter;
Fig. 4 is a characteristic graph depicting frequency characteristics of the same surface acoustic wave filter;
Fig. 5 is a structural representation of a surface acoustic wave filter of a second exemplary embodiment of the present invention;
Fig. 6 is a structural representation of another example of the same surface acoustic wave filter;
Fig. 7 is a structural representation of still another example of the same surface acoustic wave filter; and
Fig. 8 is a structural representation of a surface acoustic wave filter of the prior art.

### DESCRIPTION OF THE PREFERRED EMBODIMENTS

A surface acoustic wave filter of this invention comprises (a) a piezoelectric substrate, (b) a plurality of surface acoustic wave resonators formed on a surface of the piezoelectric substrate, and electrically connected in series, (c) a grounding electrode formed on the surface of the piezoelectric substrate, and (d) a capacitance formed on the surface of the piezoelectric substrate, in at least one location between the grounding electrode and each terminal of the surface acoustic wave resonators. The above structure can simplify designing of the surface acoustic wave filter, since it allows an entirely separate designing of the serially connected surface acoustic wave resonators and the capacitance formed between the grounding electrode and each terminal of the surface acoustic wave resonators, which had been difficult in the past.

The surface acoustic wave filter is characterized by being provided desirably with a first and a second matching circuits for maintaining matching of an input and an output impedances of the surface acoustic wave filter, and thereby the filter is able to minimize a loss in a pass band.

The surface acoustic wave filter is characterized by desirably including an inter-digital electrode to form the capacitance between the grounding electrode and each terminal of the surface acoustic wave resonators, so as to realize the capacitance with even a smaller surface area.

The surface acoustic wave filter is also characterized by desirably including an inter-digital electrode to form the capacitance between the grounding electrode and each terminal of the surface acoustic wave resonators, and having an electrode finger of the inter-digital electrode disposed in a direction generally orthogonal to a direction of electrode fingers of the surface acoustic wave resonators. This structure can form a steady capacitance around the electrode finger of the inter-digital electrode without generating surface acoustic waves.

In addition, the surface acoustic wave filter recited in claim 1 is characterized by further having a capacitance formed desirably in a space between the grounding electrode and each terminal of the surface acoustic wave resonators. This structure can form the capacitance with a simple patterning process.

Furthermore, the surface acoustic wave filter is characterized by having the capacitance, which is formed between the grounding electrode and each terminal of the surface acoustic wave resonators, arranged desirably at only one side of the surface acoustic wave resonators. This structure can avoid an increase in surface area of the piezoelectric substrate.

Moreover, the surface acoustic wave filter is characterized by desirably having a plurality of the grounding electrodes on the piezoelectric substrate, and having the capacitance formed on at least one location between each of the grounding electrodes and each terminal of the surface acoustic wave resonators. This structure can easily yield the capacitance of even larger capacity.

### First exemplary embodiment

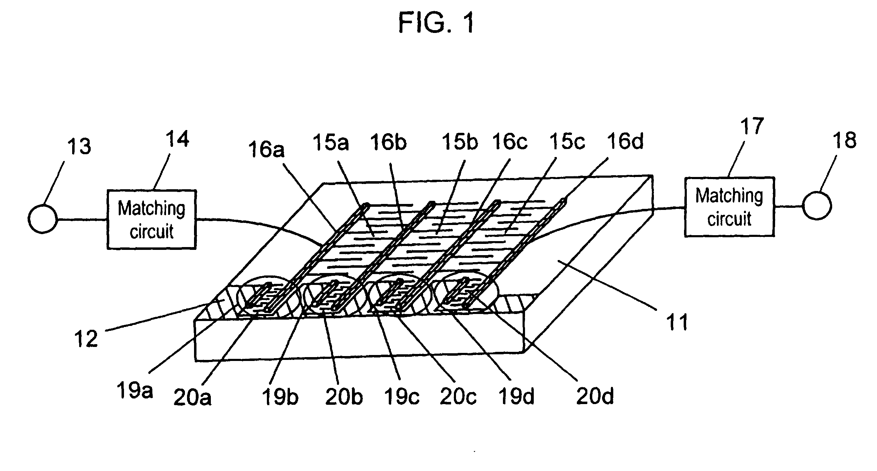

Fig. 1 shows a surface acoustic wave filter of a first exemplary embodiment of the present invention. In Fig. 1, a piezoelectric substrate 11 is provided with a grounding electrode 12 and surface acoustic wave resonators 15a through 15c formed on a surface of it. The surface acoustic wave resonators 15a through 15c are disposed serially in a direction of their electrode fingers, and they are electrically connected respectively by coupling electrodes 16a through 16d. Inter-digital electrodes 20a through 20d are formed individually in a manner to face the grounding electrode 12 from the coupling electrodes 16a through 16d, and one side of them are connected to the grounding electrode 12 to form capacitances 19a through 19d. Furthermore, the surface acoustic wave filter is constructed by electrically connecting one of terminals of an input matching circuit 14 to an input terminal 13, the other terminal to the coupling electrodes 16a, one of terminals of an output matching circuit 17 to an output terminal 18, and the other terminal to the coupling electrodes 16d respectively. They are shown in, an electric circuit of Fig. 2.

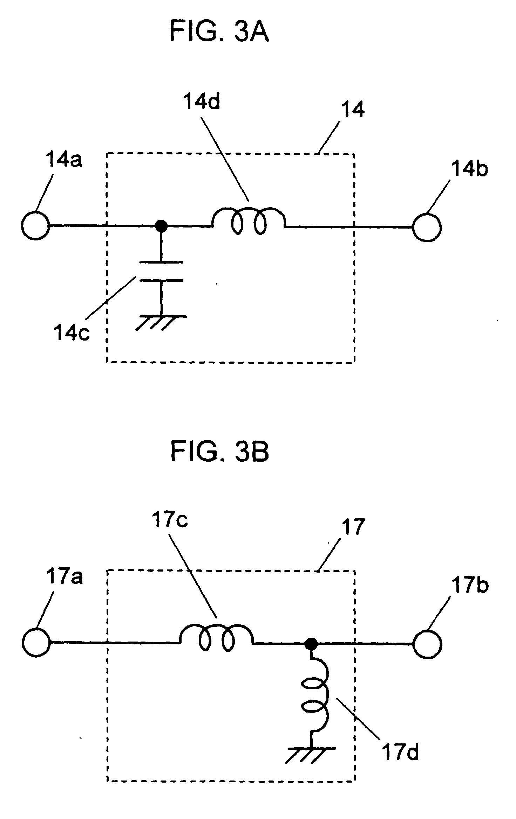

The input matching circuit 14 and the output matching circuit 17 may vary depending on individual design of the surface acoustic wave resonators 15a through 15c and the capacitances 19a through 19d. In this instance, the input matching circuit 14 has a structure including a capacitance 14c and a coil 14d, as shown in Fig. 3(a), in which three terminals, i.e. a connection terminal 14a for the input terminal 13, one terminal of the capacitance 14c and one terminal of the coil 14d, are electrically connected together, the other terminal of the capacitance 14c is grounded, and the other terminal of the coil 14d is electrically connected to a connection terminal 14b for the coupling electrode 16a of the surface acoustic wave resonator. The output matching circuit 17 has a structure including coils 17c and 17d, as shown in Fig. 3(b), in which a connection terminal 17a for the coupling electrode 16d of the surface acoustic wave resonator and one terminal of the coil 17c are electrically connected, three terminals, i.e. a connection terminal 17b for the output terminal 18, the other terminal of the coil 17c and one terminal of the coil 17d are electrically connected, and the other terminal of the coil 17d is grounded.

In the foregoing structure, the surface acoustic wave resonators 15a through 15c and the capacitances 19a through 19d can be designed individually and independently. Therefore, in a case where a large magnitude of attenuation is desired in the stop band 22 as shown in Fig. 4, a frequency characteristic can be changed easily from a curve 23 to a curve 23b by increasing the capacitances 19a through 19d without altering the surface acoustic wave resonators 15a through 15c, and thereby decreasing an impedance of the output terminal 18 to the grounding electrode 12 and increasing a signal flowing in it. In art opposite case where the magnitude of attenuation is reduced, the frequency characteristic can be changed to a curve 23a by decreasing the capacitances 19a through 19d in the like manner. The foregoing structure also realizes easily an adjustment of the magnitude of attenuation in the stop band for each of the surface acoustic wave resonators 15a through 15c individually by varying their capacity values, and thereby the surface acoustic wave filter can be designed simply.

In any of the above cases, intervening spaces between the electrode fingers need to be so designed that the inter-digital electrodes 20a through 20d are not excited with any of frequencies, at which the surface acoustic wave resonators 15a through 15c resonate, when a signal is input into the surface acoustic wave filter.

### Second exemplary embodiment

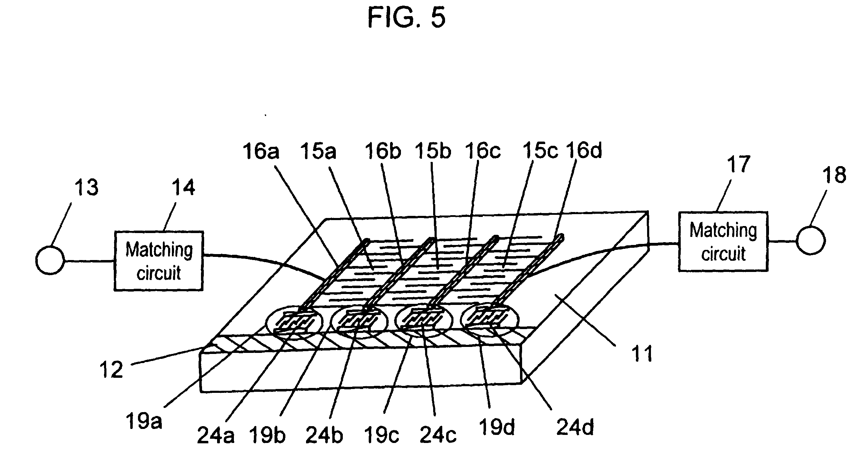

Fig. 5 depicts a surface acoustic wave filter of a second exemplary embodiment of the present invention. Since a structure of the second exemplary embodiment of this invention shown in Fig. 5 is identical in principle to the structure shown in Fig. 1, the same constituent elements are assigned the same reference numerals, and their descriptions will be omitted.

In Fig. 5, inter-digital electrodes 24a through 24d are formed with their electrode fingers arranged individually from coupling electrodes 16a through 16d toward a grounding electrode 12 in a direction orthogonal to a direction of electrode fingers of surface acoustic wave resonators 15a trough 15c. One side of the inter-digital electrodes 24a through 24d are connected with the grounding electrode 12 to form capacitances 19a through 19d.

With the foregoing structure, the inter-digital electrodes 24a through 24d are not subjected to an excitation of surface acoustic waves, when a signal passes through the surface acoustic wave resonators 15a through 15c. The foregoing structure therefore facilitates a designing of the surface acoustic wave filter, since it gives no restraint in setting an intervening space between the electrode fingers, and provides a steady capacitance.

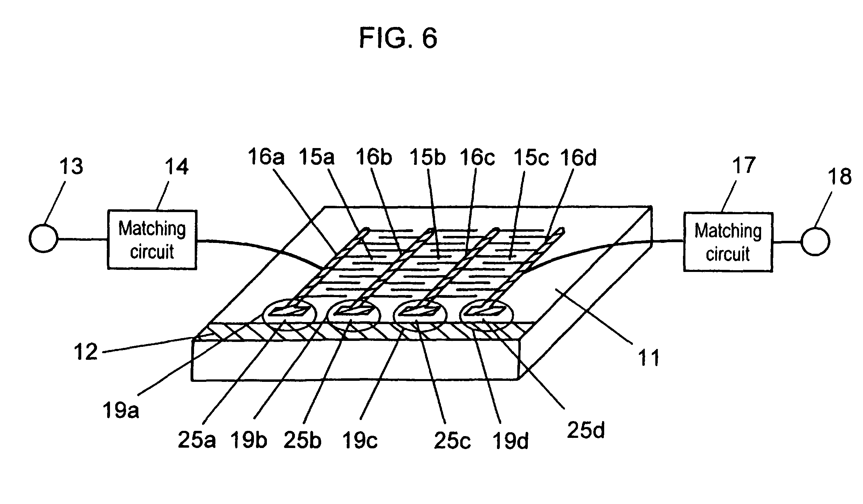

Besides, the above-noted capacitances 19a through 19d can be materialized with a simple patterning process, if the capacitances are formed in spaces 25a through 25d between the grounding electrode 12 and the coupling electrodes 16a through 16d, as shown in Fig. 6.

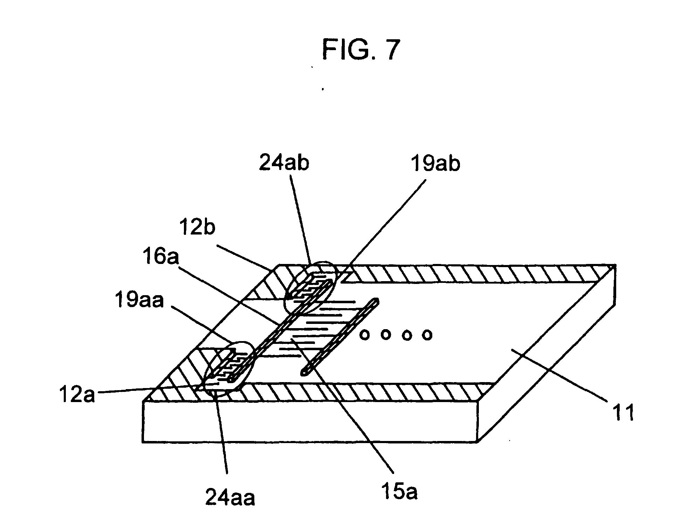

An even larger capacity value can be formed, when necessary, by providing capacitances 19aa and 19ab by disposing two grounding surfaces 12a and 12b on the piezoelectric substrate 11 and forming inter-digital electrodes 24aa and 24ab at two different locations of the coupling electrode 16a, as shown in Fig. 7.

These inter-digital electrodes 24aa and 24ab may take a form of the capacitances formed in the inter-digital electrode 20a or in the space 25a to the coupling electrode 16% as has been described in the first exemplary embodiment, as a matter of course.

Besides, the surface acoustic wave resonators can be of any number of units so long as there is a plurality of them, and a capacitance needs not be formed on every one of the coupling electrodes. The capacitances may be formed by jointly using any forms of the inter-digital electrodes 20a, 24a and the space 25a, depending on capacity values needed.

Furthermore, a surface acoustic wave filter of the present invention may be used to constitute an antenna duplexer. If this is the case, it is highly effective, if the surface acoustic wave filter is used in a system that is required to pass a low frequency region and to attenuate a high frequency region, such as a transmission filter for a GSM system.

However, since the surface acoustic wave filter of the present invention is applied with a large electric power approximately equal to or more than 1 watt in such application, a large intervening space is required between the electrode fingers of the inter-digital electrodes 20a and 24a, and for the space 25a, in order to prevent a static electric breakdown, which may occur when electric power is applied, in the electrodes on a surface of the piezoelectric substrate.

Moreover, although the input matching circuit 14 and the output matching circuit 17 have been represented by the circuits depicted in Fig. 3(a) and Fig. 3(b), an addition or a deletion may be made depending upon a design of the surface acoustic wave resonators and the capacitances.

### INDUSTRIAL APPLICABILITY

As has been described, the present invention is a surface acoustic wave filter having (a) a piezoelectric substrate, (b) a plurality of surface acoustic wave resonators formed on a surface of the piezoelectric substrate, and electrically connected in series, (c) a grounding electrode formed on the surface of the piezoelectric substrate, and (d) a capacitance formed on the surface of the piezoelectric substrate, in at least one location between the grounding electrode and each terminal of the surface acoustic wave resonators. The invention allows an entirely separate designing of the serially connected surface acoustic wave resonators and the capacitance formed between the grounding electrode and each terminal of the surface acoustic wave resonators, thereby realizing a high degree of flexibility in designing.

### Reference Numerals

- 11: Piezoelectric substrate
- 12: Grounding electrode
- 13: Input terminal
- 14: Input matching circuit
- 15a - 15c: Surface acoustic wave resonator
- 16a - 16d: Coupling electrode
- 17: Output matching circuit
- 18: Output terminal
- 19a - 19d: Capacitance
- 20a - 20d: Inter-digital electrode
- 21: Pass band of the surface acoustic wave filter
- 22: Stop band of the surface acoustic wave filter
- 23, 23a, 23b: Frequency characteristic of the surface acoustic wave filter
- 24a - 24d: Inter-digital electrode disposed in a direction generally orthogonal to a direction of electrode fingers of surface acoustic wave resonator
- 25a - 25d: Space
- 26: Rear surface electrode

## Claims

1. A surface acoustic wave filter comprising:
(a) a piezoelectric substrate;
(b) a plurality of surface acoustic wave resonators formed and electrically connected in series on a surface of said piezoelectric substrate;
(c) a grounding electrode formed on the surface of said piezoelectric substrate; and
(d) a capacitance formed on the surface of said piezoelectric substrate, in at least one location between said grounding electrode and each terminal of said surface acoustic wave resonators.

2. The surface acoustic wave filter according to claim 1, further comprising a first and a second matching circuits for matching an input and an output impedances of said surface acoustic wave filter.

3. The surface acoustic wave filter according to claim 1, wherein said capacitance formed between said grounding electrode and each terminal of said surface acoustic wave resonators comprises an inter-digital electrode.

4. The surface acoustic wave filter according to claim 1, wherein said capacitance formed between said grounding electrode and each terminal of said surface acoustic wave resonators comprises an inter-digital electrode, and an electrode finger of said inter-digital electrode is disposed in a direction generally orthogonal to a direction of electrode fingers of said surface acoustic wave resonators.

5. The surface acoustic wave filter according to claim 1, wherein said capacitance is formed in a space provided between said grounding electrode and each terminal of said surface acoustic wave resonators.

6. The surface acoustic wave filter according to claim 1, wherein said capacitance formed between said grounding electrode and each terminal of said surface acoustic wave resonators is disposed at only one side of said surface acoustic wave resonators.

7. The surface acoustic wave filter according to claim 1, wherein a plurality of said grounding electrodes are formed on the surface of said piezoelectric substrate, and a capacitance is formed in at least one location between each of said grounding electrodes and each terminal of said surface acoustic wave resonators.

8. An antenna duplexer employing at least one unit of said surface acoustic wave filter recited in claim 1.

9. A mobile communication device employing said antenna duplexer recited in claim 8 for a transmission circuit and/or a receiving circuit thereof.

## Amended claims

### Amended claims under Art. 19.1 PCT

1. (Amended) A surface acoustic wave filter comprising:
a piezoelectric substrate;
a plurality of surface acoustic wave resonators formed and electrically connected in series on a surface of said piezoelectric substrate;
a grounding electrode formed on the surface of said piezoelectric substrate; and
a capacitance formed on the surface of said piezoelectric substrate, in at least one location between said grounding electrode and each terminal of said surface acoustic wave resonators,
a first and a second matching circuits for matching an input and an output impedances of said surface acoustic wave filter;
wherein said capacitance comprises an inter-digital electrode, said inter-digital electrode arranged so that an electrode finger of said inter-digital electrode is disposed in a direction substantially orthogonal to a direction of electrode fingers of said surface acoustic wave resonators.
2. (Deleted)
3. (Deleted)
4. (Deleted)
5. The surface acoustic wave filter according to claim 1, wherein said capacitance is formed in a space provided between said grounding electrode and each terminal of said surface acoustic wave resonators.
6. The surface acoustic wave filter according to claim 1, wherein said capacitance formed between said grounding electrode and each terminal of said surface acoustic wave resonators is disposed at only one side of said surface acoustic wave resonators.
7. The surface acoustic wave filter according to claim 1, wherein a plurality of said grounding electrodes are formed on the surface of said piezoelectric substrate, and a capacitance is formed in at least one location between each of said grounding electrodes and each terminal of said surface acoustic wave resonators.
8. An antenna duplexer employing at least one unit of said surface acoustic wave filter recited in claim 1.
9. A mobile communication device employing said antenna duplexer recited in claim 8 for a transmission circuit and/or a receiving circuit thereof.
